# EUROPÄISCHE PATENTANMELDUNG

(11) **EP 0 971 388 A2**
(43) Veröffentlichungstag der Anmeldung: **12.01.2000**
(21) Anmeldenummer: 99113001.4
(22) Anmeldetag: 06.07.1999
(51) Int. Cl.: H01J 37/34

(54) **Vorrichtung und Verfahren zum mehrlagigen PVD-Beschichten von Substraten**

(30) Priorität: 07.07.1998 DE 19830223
(71) Anmelder: Techno-Coat Oberflächentechnik GmbH, 02763 Zittau (DE)
(72) Erfinder: Hollstein, Frank, Dr., OT Wittgensdorf, 02788 Hirschfelde (DE)
(74) Vertreter: Patentanwälte Lippert, Stachow, Schmidt & Partner

(57) **Zusammenfassung**

Die Erfindung betrifft eine Vorrichtung und ein Verfahren zum mehrlagigen PVD-Beschichten (**P**hysical **V**apour **D**eposition) von Substraten, vorzugsweise mit einer Magnetron-Sputter-Anlage. Die Vorrichtung enthält als erfindungsgemäße Komponente ein oder mehrere, vorzugsweise gekühlte Zerstäubungstargetsysteme. Ein Zerstäubungstargetsystem besteht aus mehreren Einzeltargets, die aus unterschiedlichen Targetmaterialien hergestellt und in Form eines im Querschnitt gleichseitigen Hohlvielecks angeordnet sind. Die Anordnung ist um die Hohlvieleckssymmetrieachse drehbar gelagert. Im Inneren des Hohlvielecks sind vorzugsweise Magnetrons (innere Magnetrons) vorhanden. Durch eine Abschirmung ist immer nur ein Einzeltarget des Zerstäubungstargetsystems dem Ionenbeschuß ausgesetzt. Die Mehrlagenbeschichtung wird erfindungsgemäß entsprechend einer Beschichtungsstrategie durch planmäßig gesteuertes, stufenweises Drehen des Zerstäubungstargetsystems in Winkelschritten, die dem Symmetriegrad des Hohlvielecks entsprechen, vorgenommen. Neben dem Magnetron-Sputtern ist die Erfindung auch auf andere PVD-Beschichtungsverfahren anwendbar, vorzugsweise dem Beschichten mittels Lichtbogen-, Niedervolt-Elektronenstrahl- und/oder lasergestützten Verdampfens oder daraus kombinierter Verfahren.

## Beschreibung

Die Erfindung betrifft eine Vorrichtung und ein Verfahren zum mehrlagigen PVD-Beschichten von Substraten, vorzugsweise mit einer Magnetron-Sputter-Anlage.

Der Begriff Magnetron-Sputtern steht für eine industriell wohl etablierte Technologie zum PVD-Beschichten (**P**hysical **V**apour **D**eposition) von Gegenständen (Substraten) durch Zerstäuben (Sputtern) von Feststoffen (Targets). Die Zerstäubung des Targets erfolgt dabei durch Beschuß mit energiereichen Ionen, zumeist Ionen des Edelgases Argon (Sputtergas). Initiiert wird der Ionenbeschuß durch Gasentladungsprozesse. Die Ionen des Sputtergases werden dabei durch elektrische Felder gezielt in Richtung des Targets auf derart hohe kinetische Energien beschleunigt, daß sie einzelne Atome und sogar Kristallite aus dem Target herausschlagen. Der Prozeß kann sowohl im Gleichspannungsbetrieb (dc-Magnetron-Sputtern) als auch im Wechselspannungsbetrieb (ac-Magnetron-Sputtern) durchgeführt werden. Durch eine wohl definierte Anordnung von Permanentmagneten (hier bezeichnet als "äußeres Magnetron" zur begrifflichen Abgrenzung von der weiter unten eingeführten Bezeichnung "inneres Magnetron") unmittelbar hinter dem Target wird durch eine Flugbahnverzerrung der ebenfalls im Plasma vorhandenen Elektronen eine merkliche Erhöhung der Gasplasmadichte vor dem Target erzielt und so die Zerstäubungsgeschwindigkeit gegenüber einem Ionenbeschuß ohne Verwendung der Permanentmagneten bedeutend erhöht (US 4,166,018). Eine bevorzugte Art des Magnetron-Sputterns ist das unbalancierte Magnetron-Sputtern. Hier wird zusätzlich durch zumeist außerhalb der Beschichtungskammer angebrachte Ringspulen die relevante Reichweite der magnetischen Feldlinien bis weit in das Innere der Beschichtungskammer verlängert. Außerdem kann das Magnetfeld durch Steuerung des Spulenstromes vorteilhaft modifiziert werden.
Um eine möglichst große mittlere freie Weglänge der zumeist neutralen Targetdampfteilchen (Sputterteilchen) zu gewährleisten, wird der gesamte Prozeß des Magnetron-Sputterns in einer geschlossenen Beschichtungskammer unter Hochvakuumbedingungen bei einem Innendruck von ca. 10⁻³ bis 10⁻⁶ mbar durchgeführt. Ein Teil der Sputterteilchen lagert sich auf der Oberfläche der ebenfalls in der Beschichtungskammer angeordneten Substrate ab und ummanteln diese im Laufe der Beschichtung mit einer Dünnschicht. Durch Anlegen einer negativen elektrischen Spannung (BIAS) an die Substrate bzw., bei elektrisch nicht leitenden Substraten, an eine BIAS-Kathode in der Nähe der Substrate (zumeist Komponenten des Substrathaltersystems), kann die Schichtmorphologie zusätzlich gezielt beeinflußt werden. Die Dünnschicht hat bei industriell relevanten Aufgabenstellungen eine mittlere Dicke im Bereich von ca. 0.1 bis 5 µm. Durch Einmischen eines oder mehrerer Reaktivgase, zumeist Stickstoff, Sauerstoff oder ein kohlenstoffhaltiges Gas, in die Beschichtungskammer können durch chemische Reaktionen oder Einlagerung der Reaktivgasatome in die atomare Dünnschichtstruktur ebenfalls gezielte Modifikationen der Schichteigenschaften, wie Härte oder Haftfestigkeit, generiert werden. Bei Verwendung mehrerer unterschiedlicher Targetmaterialien, entweder in Form eines Mischtargets oder mindestens zweier Reintargets, lassen sich durch mehrlagiges Beschichten die Eigenschaften der Gesamtschicht weiter nutzbringend beeinflussen. Mehrlagenschichten (super lattices) werden zumeist durch wohl definiertes, alternierendes "Aus- und Einschalten" einzelner Targets hergestellt. Die Verbesserung der Qualität und Ökonomie beim Mehrlagenbeschichten ist das Hauptanliegen der Erfindung.
Derartige mehrlagige PVD-Beschichtungen sind überall dort vorteilhaft, wo die einzelnen Schichten unterschiedliche Funktionen übernehmen können. Beispielsweise ist es mit einer Zweilagenschicht möglich, durch eine erste Schicht eine gute Haftfestigkeit zum Substratmaterial herzustellen und mittels einer darüber liegenden zweiten Schicht die eigentlich gewünschte Oberflächenfunktionalität, z.B. tribologisches Verhalten oder dekoratives Erscheinungsbild, zu generieren.
Vorrichtungen zur Durchführung des Mehrlagen-Magnetron-Sputterns sind aus einer Reihe von Veröffentlichungen und Patentschriften bekannt. Die mit der Erfindung in Beziehung stehenden Vorrichtungen und Verfahren unterscheiden sich vornehmlich in der Auslegung des gerätetechnischen Subsystems Target-Kathode-Magnetron. So wird in US 4,166,018 das Planar-Magnetron beschrieben. Das rechteckig geformte und vorzugsweise gleichzeitig als Kathode dienende Target ist dabei unmittelbar über einem Permanentmagnetensatz gekühlt montiert. Durch das Magnetfeld wird die Ionisationsdichte des Sputtergases in der Nähe des Targets wesentlich erhöht und damit die Abstäubungsrate positiv beeinflußt. Nachteilig ist der stark inhomogene Materialabtrag, der sich in Form von Erosionsgräben auf dem Target zeigt. Zur Verbesserung des Materialabtrages wird in US 4,356,073 eine hohlzylindrische Targetgeometrie einschließlich permanentmagnetischer Mittel vorgeschlagen. Durch allmähliches Drehen des Targets um seine Rotationsachse kann die Abtragsinhomogenität weitgehend ausgeglichen werden. Weiterhin wird dort beschrieben, wie durch azimutal segmentierte Unterschiede in der Materialzusammensetzung des Hohlzylindertargets und durch Drehen des Targets unterschiedliche Materialien auf dem Substrat in Form von Mehrlagenschichten abgeschieden werden können. Neben den komplizierten Herstellungs- und Montageverfahren für derart azimutal segmentierte Hohlzylindertargets wirkt sich nachteilig aus, daß sich ein gleichzeitiges und unerwünschtes Zerstäuben unterschiedlicher Segmente nur schwer vermeiden läßt und es somit ungewollt zu einer Mischbeschichtung des Substrats kommt. An Stelle eines azimutal segmentierten Hohlzylindertargets wird in US 4,443,318 ein aus vielen einzelnen planaren Targetstreifen zusammengesetztes Targetsystem vorgeschlagen. Der zylindrische Querschnitt wird so durch einen polygonen Querschnitt angenähert und die einzelnen Targetstreifen lassen sich nach ihrem Verschleiß leichter wechseln als beim azimutal segmentierten Hohlzylindertarget. Durch diese Modifikation wird allerdings der Vorteil der verbesserten Ausnutzung des Targetmaterials, wie es für das Hohlzylindertarget nach US 4,356,073 vorteilhaft ist, wieder aufgegeben.

Nachteilig bei allen bekannten Lösungen zum mehrlagigen PVD-Beschichten von Substraten mit einer Magnetron-Sputter-Anlage ist, daß eine derartige Beschichtung im wesentlichen mit folgenden Problemen behaftet ist: Entweder müssen einzelne Targets alternierend, meistens durch Ausschalten und Abdecken mit Hilfe eines sogenannten Shutters, vom Beschichtungsprozeß ausgeschlossen werden, wodurch sich die Gesamtproduktivität einer Anlage verringert, oder der Beschichtungsprozeß muß unterbrochen werden und die Folgeschicht wird erst nach einem mechanischen Targetwechsel aufgedampft. Ein Targetwechsel bringt nachteilig neben den mechanischen Gerätemanipulationen immer auch einen zeitaufwendigen, vorgeschalteten Belüftungs- und nachgeschalteten Evakuierungsprozeß mit sich. Weiterhin besteht bei einem mechanischen Targetwechsel in hohem Maße immer die Gefahr, daß es zu unerwünschten Verunreinigungen auf der bereits erzeugten Substratoberfläche kommt mit nachteiligen Folgen für die Qualität der Gesamtschicht. Zur Umgehung eines Targetwechsels besteht als Alternative die Möglichkeit, ein Mehrkammersystem zu verwenden. Dies ist jedoch mit unökonomisch überproportionalen Investitions-, Betreibungs- und Wartungskosten verbunden. Derartige Mehrkammer-Sputter-Systeme sind für die Klein- und Mittelserienproduktion nicht konkurrenzfähig.
In EP 0495215 und GB 1,194,428 sind Verdampfungsvorrichtungen mit sogenannten Wendetargets beschrieben. An den Enden eines beispielsweise vierachsigen Kreuzhalters sind zu verdampfende Targetplatten montiert. Durch Drehung des Kreuzhalters kann jeweils eine andere Targetplatte in Arbeitsposition bezüglich des Beschichtungsraumes gebracht werden. Nachteilig bei beiden Patentschriften ist, daß magnetische Mittel zur Erzeugung des Magnetroneffektes nicht vorgesehen sind.

Der Erfindung liegt daher die Aufgabe zugrunde, eine Vorrichtung und ein Verfahren zum mehrlagigen PVD-Beschichten in einer Magnetron-Sputter-Anlage mit vorzugsweise nur einer separaten Beschichtungskammer zu entwickeln. Dabei soll weder die Gesamtproduktivität der Anlage durch partielles "Abschalten" einzelner Targets verringert, noch der Beschichtungsprozeß durch einen mechanischen Targetwechsel unterbrochen werden. Die Erfindung soll vorzugsweise in der Klein- und Mittelserienproduktion (Job coating) als auch im Laborbereich ökonomisch anwendbar sein.

Diese Aufgabe wird erfindungsgemäß mit einer Magnetron-Sputter-Anlage entsprechend dem Oberbegriff des Patentanspruchs 1 dadurch gelöst, daß ein neuartiges und als Kathode nutzbares Zerstäubungstargetsystem entwickelt und eingesetzt wird. Dieses Zerstäubungstargetsystem besteht aus mehreren rechteckigen Einzeltargets, die in Form eines gleichseitigen Vielecks miteinander verbunden sind und so im Querschnitt ein Hohlvieleck bilden. Das erfindungsgemäße Zerstäubungstargetsystem ist vor dem äußeren Magnetron vorzugsweise mittig angeordnet und kann durch Drehen um seine Symmetrieachse in Schritten von ± 360/N Grad manipuliert werden, wobei N für den Symmetriegrad steht. Seitlich ist das Zerstäubungstargetsystem mit einer mechanischen Abschirmung versehen, so daß vorzugsweise jeweils nur ein Einzeltarget dem Ionenbeschuß ausgesetzt ist. Durch Bestücken des Zerstäubungstargetsystem mit mindestens zwei unterschiedlichen Targetmaterialien läßt sich das dem Ionenbeschuß ausgesetzte Zerstäubungsmaterial ohne Prozeßunterbrechung problemlos durch einen Drehschritt des Zerstäubungstargetsystems wechseln.
Das Innere des Hohlvielecks ist vorzugsweise mit Permanentmagneten (innere Magnetrons) wohl definiert ausgerüstet. Dadurch läßt sich der Magnetroneffekt beim Ionisationsprozeß wesentlich verbessern.
In einer weiteren vorteilhaften Ausgestaltung sind die Einzeltargets des Zerstäubungstargetsystems auf Kühlmittel führenden und vorzugsweise elektrisch gegeneinander isolierten Platten montiert (Anspruch 2). Eine Targetkühlung ist besonders bei erhöhter Sputterleistung oder bei längeren Beschichtungszeiten, etwa im Bereich von 15 Minuten bis zu vier Stunden, vorteilhaft. Die elektrisch gegeneinander isolierten Platten sind vorteilhaft gleichzeitig als Kathoden verwendbar, falls das Targetmaterial selbst nicht elektrisch leitend ist. In diesem Falle ist das Magnetron-Sputtern im Wechselspannungsbetrieb (ac-Magnetron-Sputtern) durchzuführen im Gegensatz zum meist üblichen Gleichspannungsbetrieb (dc-Magnetron-Sputtern) bei elektrisch leitfähigen Targetmaterialien.

Weiterhin ist es entsprechend Anspruch 3 vorgesehen, mehrere der erfindungsgemäßen Zerstäubungstargetsysteme so vor einem äußeren Magnetron anzuordnen, daß sie gerade noch einzeln vollständig drehbar sind. "Gerade noch einzeln vollständig drehbar" heißt, daß sich die einzelnen Zerstäubungstargets in jede beliebige azimutale Winkelposition bringen lassen, daß sie sich jedoch in bevorzugten Winkelpositionen an den Kanten gegenseitig genau linienartig berühren und so den Ionengeschossen insgesamt eine quasi geschlossene Sputterfläche anbieten. Damit brauchen lediglich die zwei äußeren Zerstäubungstargetsysteme mechanisch vor einem seitlichen Ionenbeschuß abgeschirmt werden. Durch eine derartige Anordung mehrerer Zerstäubungstargetsysteme wird, beispielsweise bei Zerstäubungstargetsystemen mit "Dreieckssymmetrie" im Querschnitt (Triangelanordnung), des Weiteren vorteilhaft die Sputterfläche relativ zum Abstand von den Permanentmagneten des äußeren Magnetrons vergrößert. Bei Betrachtung nur eines einzelnen, räumlich isolierten Zerstäubungstargetsystems ist dies nicht möglich. Dort zieht eine Vergrößerung der Sputterfläche bei sonst gleichbleibenden Verhältnissen immer auch nachteilig eine Vergrößerung des Abstandes der Sputterfläche von dem äußeren Magnetron nach sich.
Eine Bestückung der Beschichtungskammer mit mehreren der erfindungsgemäßen Subkomponenten ist eine weitere vorteilhafte Ausgestaltung der Erfindung (Anspruch 4) im Sinne einer Produktivitätserhöhung der Magnetron-Sputter-Anlage.
Mit der erfindungsgemäßen Vorrichtung kann nun durch wohl definiertes Drehen der Zerstäubungstargetsysteme in Schritten von 360/N Grad, wobei N für den Symmetriegrad des Zerstäubungstargetsystems steht, ein neuartiges Verfahren zur mehrlagigen PVD-Beschichtung realisiert werden (Anspruch 5). Dabei wird ohne Prozeßunterbrechung entsprechend eines zeitlich vorgegebenen Steuerungsablaufes jeweils ein anderes Targetmaterial dem Ionenbeschuß ausgesetzt und damit eine Mehrlagenbeschichtung realisiert. Durch Einmischen von Reaktivgas in die Beschichtungskammer ist der gesamte Beschichtungsprozeß reaktiv durchführbar (Anspruch 6), womit vorteilhaft das Spektrum der produzierbaren Schichten und Schichteigenschaften wesentlich erweitert wird.
Das erfindungsgemäße Zerstäubungstargetsystem ist nicht auf das Magnetron-Sputtern beschränkt. Es kann auch bei anderen Zerstäubungs- bzw. Verdampfungsverfahren nutzbringend eingesetzt werden, vorzugsweise beim Lichtbogenverdampfen oder bei den relativ neuen Verfahren des laserinduzierten Verdampfens (Laser-Ablation) bzw. daraus kombinierten Verfahren (Anspruch 7).
Der Vorteil der Erfindung gegenüber dem Stand der Technik besteht vor allem darin, daß bei einem Beschichtungsprozeß alternativ mehrere Targetmaterialien zur Verfügung stehen und ein Targetwechsel ohne Prozeßunterbrechung möglich ist, was sowohl die Gesamtproduktivität einer Anlage als auch die Schichtqualität merklich zu verbessern gestattet. Gleichzeitig wird bei Anwesenheit von zwei oder mehr der erfindungsgemäßen Zerstäubungstargetsysteme durch die Erfindung die Anzahl der Variationsmöglichkeiten bei der Erzeugung von Mehrlagen-Mischschichten und/oder Gradientenschichten bedeutend vergrößert.

Die Erfindung soll nachfolgend anhand eines Ausführungsbeispiels näher erläutert werden. Es zeigen in schematischer Darstellung
- Fig. 1: : Querschnitt einer unbalancierten Magnetron-Sputter-Anlage mit zwei Zerstäubungsquellen, bestehend aus jeweils drei Zerstäubungstargetsystemen in Triangelanordnung.
- Fig. 2:: Zerstäubungsquelle mit drei Zerstäubungstargetsystemen in Triangelanordnung.
- Fig. 3:: Zerstäubungstargetsystem mit vier Einzeltargets in Quadratanodnung.
- Fig. 4:: Anordung mit drei einzeln gerade noch ungestört drehbaren Zertäubungstargetsystemen mit jeweils
a) vier Einzeltargets (Quadratanordnung),
b) drei Einzeltargets (Triangelanordnung).

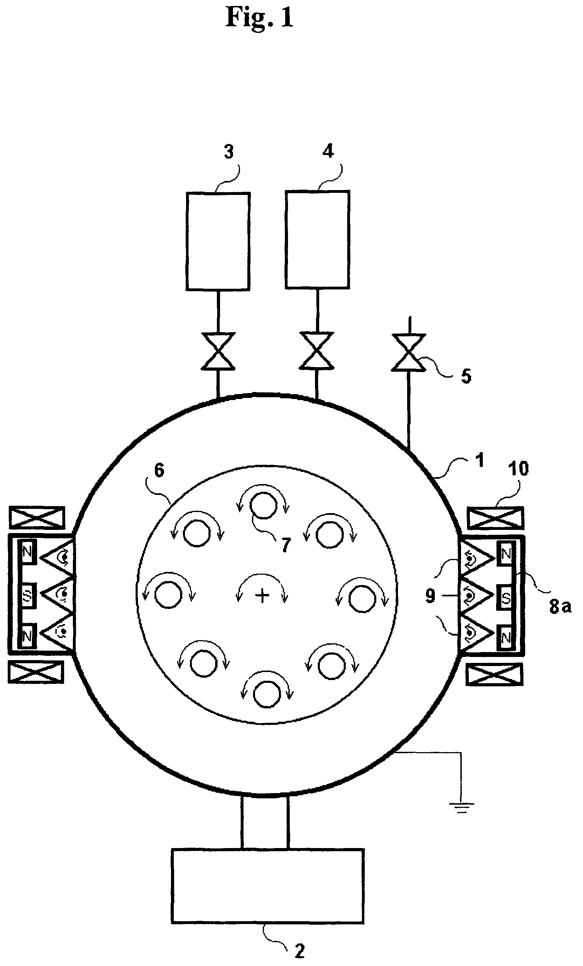

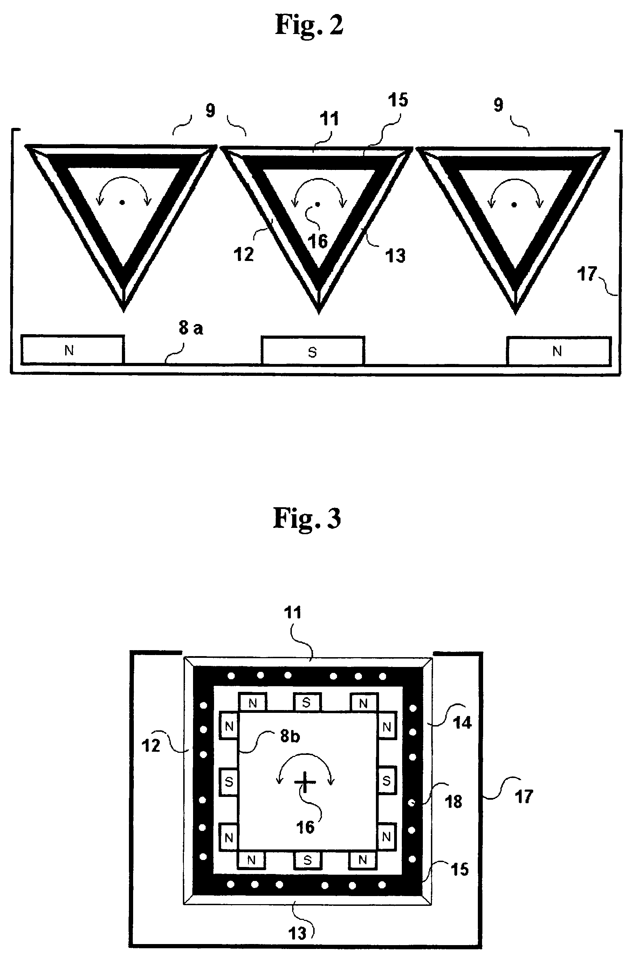

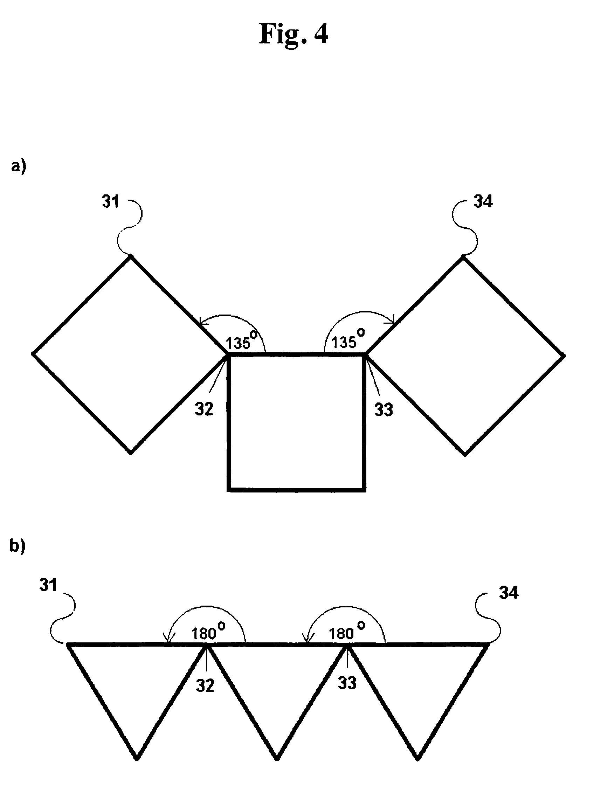

Der Querschnitt einer Vorrichtung der erfindungsgemäßen Art zum mehrlagigen PVD-Beschichten durch Magnetron-Sputtern, hier vorteilhaft möglich als unbalanciertes Magnetron-Sputtern, ist in **Fig. 1** dargestellt. Eine vorzugsweise aus Edelstahl mit einer Wandstärke von ca. 2,5 cm gefertigte Beschichtungskammer **1** ist mittels eines Evakuierungssystems **2** auf einen Innendruck von bis zu 10⁻⁶ mbar evakuierbar. Über die ventil- und druckgesteuerte Arbeitsgaszuführung **3** wird das für die Gasentladungsprozesse notwendige Arbeitsgas, vorzugsweise Argon, der Beschichtungskammer **1** zugeführt. In zwei seitlichen Ausbuchtungen der Beschichtungskammer **1** ist jeweils eine Zerstäubungsquelle angeordnet, bestehend aus einem äußeren Magnetron **8a** und drei Zerstäubungstargetsystemen **9.** Die drei Zerstäubungstargetsysteme **9** sind als Triangelanordnung konstruiert und werden anhand der Fig. 2 später detailierter beschrieben. Zur Erreichung eines unbalancierten Magnetroneffektes wird das Magnetfeld des äußeren Magnetrons **8a** von einem Ringspulenmagnetfeld überlagert, das mittels außerhalb von der Beschichtungskammer **1** angeordneter Ringspulen **10** erzeugt wird. Die zu beschichtenden Substrate **7** sind auf einem Substrathaltertisch **6** angeordnet. Der Substrathaltertisch **6** rotiert Motor getrieben und von einer in Fig. 1 nicht dargestellten Prozeßsteuerung hinsichtlich seiner Drehfrequenz steuerbar um die vertikale Mittelachse der Beschichtungskammer **1.** Die Substrate **7,** in Fig. 1 schematisch als zylindrische Formteile dargestellt, sind auf dem gegenüber der Beschichtungskammer **1** elektrisch isolierten Substrathaltertisch **6** durch nicht dargestellte Rotation bewirkende Mittel um horizontale Achsen und vorzugsweise unter Nutzung der Prozeßsteuerung drehbar. Mit Hilfe der in Fig. 1 angedeuteten Zweifachrotation der Substrate **7** wird prozeßseitig eine gleichmäßige Rundumbeschichtung der Substrate **7** gewährleistet. Die Bestückung der Beschichtungskammer **1** mit Substraten **7** erfolgt über eine hermetisch abgedichtete Türöffnung in der Beschichtungskammer **1,** ohne Darstellung in Fig. 1. Die Belüftung der Beschichtungskammer **1** wird nach einem Beschichtungsprozeß über das Belüftungsventil **5** vorgenommen. Die Reaktivgaszuführung **4** dient der Zumischung eines Reaktivgases, vorzugsweise Stickstoff, Sauerstoff oder ein kohlenstoffhaltiges Gas, in das Gasionenplasma während der Beschichtung zur reaktiven Prozeßführung. Durch eine wohl definierte elektrische Hochspannung, erzeugt von einer in Fig. 1 nicht dargestellten Stromversorgungseinrichtung, anliegend zwischen der geerdeten Beschichtungskammer **1** und vorzugsweise den gegenüber der Beschichtungskammer **1** und gegenseitig elektrisch isolierten und einzeln schaltbaren Einzeltargets der Zerstäubungstargetsysteme **9,** wird der Gasentladungsprozeß in der Beschichtungskammer **1** bei einem Arbeitsgasdruck von vorzugsweise 10⁻³ mbar gestartet und während der Beschichtung und mittels der Prozeßsteuerung gesteuert und geregelt aufrechterhalten.
In **Fig. 2** werden die in Fig. 1 dargestellten zwei Zerstäubungsquellen detaillierter gezeigt. Über dem äußeren Magnetron **8a,** bestehend aus drei Permanentmagneten, die alternierendpolig auf einer magnetisch neutralen Platte innerhalb der mechanischen Abschirmung **17** montiert sind, sind nebeneinander drei Zerstäubungstargetsysteme **9** angeordnet. Ein Zerstäubungstargetsystem **9** besteht dabei aus drei Einzeltargets **11, 12** und **13,** die auf Kühlmittel führenden Platten **15** montiert sind. Die drei Kühlmittel führenden Platten **15** haben einzeln die Form eines Rechtecks und sind so miteinander verbunden, daß sie im Querschnitt die Form eines Hohldreiecks annehmen. Die Kühlung der Kühlmittel führenden Platten **15** erfolgt vorzugsweise mittels in Fig. 2 nicht dargestellter Kühlröhren **18** (siehe dazu Fig. 3) im Inneren der Kühlmittel führenden Platten **15,** in denen ein Kühlmittel strömt. An den Berührungslinien zweier Kühlmittel führender Platten **15** ist eine nicht dargestellte elektrische Isolierung vorhanden. Jedes der drei durch die Kühlmittel führenden Platten **15** gebildeten Hohldreiecke ist vertikal um die Symmetrieachse **16** drehbar, und von der Prozeßsteuerung steuerbar und von nicht dargestellten Rotation bewirkenden Mitteln angetrieben, gelagert.
Anhand der Fig. 1 und 2 wird nachfolgend das erfindungsgemäße Verfahren zum mehrlagigen PVD-Beschichten von Substraten mit einer Magnetron-Sputter-Anlage näher beschrieben. Erzeugt werden soll exemplarisch eine Zweilagenschicht, bestehend aus einer ca. 0.3 µm dicken Chrom-Unterschicht und einer ca. 1.5 µm dicken Zirkonnitrid-Deckschicht. Zu diesem Zweck wird als Targetmaterial für die Einzeltargets **11** hochreines Chrom verwendet und für die Einzeltargets **12** und **13** hochreines Zirkonium. In der Startposition werden die drei Zerstäubungstargetsysteme **9** der zwei Zerstäubungsquellen in der Vorrichtung nach Fig. 1 derartig azimutal positioniert, daß die Einzeltargets **11** der Zerstäubungstargetsysteme **9** eine quasi geschlossene, ebene Sputterfläche für den Ionenbeschuß bilden. Nach dem Beschicken der Beschichtungskammer **1** mit Substraten **7,** die zuvor gewaschen und mit Hilfe von Ultraschall gereinigt worden sind, wird der Beschichtungsprozeß gestartet. Der Beschichtungsprozeß wird, wie beim Magnetron-Sputtern üblich, in folgenden, zeitlich nacheinander ablaufenden Phasen realisiert: Evakuieren, Heizen, Ätzen, Beschichten, Abkühlen, Belüften. Zur Erläuterung des erfindungsgemäßen Verfahrens wird nachfolgend lediglich die Beschichtungsphase näher betrachtet. Die Beschichtungsphase unterteilt sich entsprechend der postulierten Zielstellung, eine Zweilagenschicht zu erzeugen, in zwei Unterphasen. In der ersten Unterphase wird die Chrom-Unterschicht gebildet. Dazu werden die Zerstäubungstargetsysteme **9** bezüglich ihrer azimutalen Ausrichtung in ihrer Startposition belassen und der Zerstäubungsprozeß mit Argon-Ionen bei einem Druck in der Beschichtungskammer **1** von 10⁻³ mbar realisiert. Als Kathoden sind die Einzeltargets **11** geschaltet mit einer Gleichspannung zur geerdeten Beschichtungskammer **1** von vorzugsweise -400 V. Bei einer Bestäubungsgeschwindigkeit von vorzugsweise 15 nm pro Minute, die mit Hilfe der Prozeßsteuerung erreicht wird, ist die erste Unterphase der Beschichtungsphase nach 25 Minuten beendet. Die zweite Unterphase beginnt mit einem Drehschritt der Zerstäubungstargetsysteme **9,** der eine Drehung der Zerstäubungstargetsysteme **9** um 120° um ihre Rotationsachsen **16** bewirkt. Damit werden die dem Ionenbeschuß ausgesetzten Targetmaterialien quasi momentan von Chrom nach Zirkonium gewechselt ohne jegliche Beeinflussung der anderen Prozeßparameter und ohne Unterbrechung der Beschichtungsphase. Zeitgleich wird das Reaktivgas Stickstoff über die Reaktivgaszuführung **4** in die Beschichtungskammer **1** eingemischt bis zu einem Stickstoffpartialdruck von vorzugsweise 10⁻³ mbar. Bei einer Bestäubungsgeschwindigkeit von vorzugsweise 15 nm pro Minute, ist die zweite Unterphase der Beschichtungsphase nach 100 Minuten beendet und die Zweilagenschicht auf den Substraten **7** abgeschieden. Der Beschichtungsprozeß wird anschließend nach einer ca. 20-minütigen Abkühlphase und nach einem Belüften der Beschichtungskammer **1** durch Öffnen des Belüftungsventils **5** beendet.
In **Fig. 3** ist der Hohlraum des Zerstäubungstargetsystems vorteilhaft mit vier inneren Magnetrons **8b** bestückt, die unmittelbar hinter den Kühlmittel führenden Platten **15,** auf denen die Einzeltargets **11** bis **14** montiert sind, angeordnet sind. Dadurch wird eine Verbesserung der Wirkung des Magnetfeldes auf den Gasionisationsprozeß in der Beschichtungskammer **1** erreicht.
Anhand von **Fig. 4** wird die vorteilhafte Ausgestaltung der Erfindung entsprechend Anspruch 3 näher erläutert. Zur Verringerung des Abstandes der dem Ionenbeschuß dargebotenen Sputterfläche zum äußeren Magnetron **8a** ist es vorteilhaft, mehrere der erfindungsgemäßen Zerstäubungstargetsysteme vor einem äußeren Magnetron derart eng aneinander zu reihen, daß sie sich gerade noch einzeln und ohne gegenseitige Behinderung vollständig drehen lassen und die Gesamtsputterfläche, in **Fig. 4** im horizontalen Schnitt durch eine Linie charakterisiert, bestehend aus der Verbindung von der ersten Targetkante **31** über die erste **32** und die zweite Targetberührungslinie **33** zur zweiten Targetkante **34,** noch quasi geschlossen bleibt. Während sich im Falle einer Triangelanordung der einzelnen Targetzerstäubungssysteme **(Fig. 4b)** eine besonders vorteilhafte ebene Gesamtsputterfläche ergeben kann, und zwar wenn der Einschlußwinkel der Teilsputterflächen genau 180° beträgt, dürfen im Falle einer Quadratanordnung die einzelnen Teilsputterflächen höchsten einen Winkel von 135° einschließen entsprechend **Fig. 4a.**

### Liste der Bezugszeichen

- 1: Beschichtungskammer
- 2: Evakuierungssystem
- 3: Arbeitsgaszuführung
- 4: Reaktivgaszuführung
- 5: Belüftungsventil
- 6: Substrathaltertisch
- 7: Substrat
- 8a: äußeres Magnetron
- 8b: inneres Magnetron
- 9: Zerstäubungstargetsystem
- 10: Ringspuhlenmagnet
- 11: erstes Target
- 12: zweites Target
- 13: drittes Target
- 14: viertes Target
- 15: Kühlmittel führende Platte
- 16: Rotationsachse
- 17: mechanische Abschirmung
- 18: Kühlröhre
- 31: erste Targetkante
- 32: erste Targetberührungslinie
- 33: zweite Targetberührungslinie
- 34: zweite Targetkante

## Patentansprüche

1. Vorrichtung zum mehrlagigen PVD-Beschichten von Substraten in einer evakuierbaren Beschichtungskammer mit ventilgesteuerten Gaseinlaß- und Gasauslaßöffnungen, mit einem oder mehreren Magnetrons (äußere Magnetrons), angeordnet vorzugsweise in der Nähe der Innenwand der Beschichtungskammer, mit Stromversorgungseinrichtungen zur Erzeugung von Kathodenspannungen und Substratvorspannungen und einem oder mehreren Arbeits- und/oder Reaktivgasen in der Beschichtungskammer, mit denen durch Gasentladungsprozesse unter Hochvakuumbedingungen Feststoffpartikel von einem Target abgestäubt werden können, **gekennzeichnet dadurch,** daß
- vor dem äußereren Magnetron ein vorzugsweise mittig angeordnetes und als Kathode nutzbares Zerstäubungstargetsystem vorhanden ist,
- das Zerstäubungstargetsystem aus mehreren, vorzugsweise drei oder vier und vorzugsweise rechteckigen, durch Ionenbeschuß zerstäubbare Einzeltargets besteht, die in Form eines im Querschnitt gleichseitigen Hohlvielecks, vorzugsweise eines Hohldreiecks (Triangelanordnung) oder -vierecks (Quadratanordnung), angeordnet sind,
- im Inneren des Hohlvielecks vorzugsweise ein oder mehrere Magnetrons vorhanden sind (innere Magnetrons),
- zumindest ein Einzeltarget aus einem anderen Targetmaterial besteht als die anderen Einzeltargets des Zerstäubungstargetsystems,
- durch eine Abschirmung vorzugsweise nur ein Einzeltarget des Zerstäubungstargetsystems dem Ionenbeschuß ausgesetzt ist und
- das Zerstäubungstargetsystem um seine Vieleckssymmetrieachse drehbar ist, vorzugsweise derart, daß durch Drehen des Zerstäubungstargetsystems um seine Vieleckssymmetrieachse in Winkelschritten, die dem Symmetriegrad des Hohlvielecks entsprechen, ein anderes Einzeltarget des Zerstäubungstargetsystems dem Ionenbeschuß aussetzbar ist.

2. Vorrichtung nach Anspruch 1, gekennzeichnet dadurch , daß die Einzeltargets des Zerstäubungstargetsystems auf Kühlmittel führenden und vorzugsweise elektrisch gegeneinander isolierten Platten montiert sind.

3. Vorrichtung nach den Ansprüchen 1 oder 2, gekennzeichnet dadurch, daß vor einem äußeren Magnetron mehrere, vorzugsweise gleichartige Zerstäubungstargetsysteme derart angeordnet sind, daß sie sich gerade noch einzeln und ohne gegenseitige Behinderung um ihre Vieleckssymmetrieachsen vollständig drehen lassen.

4. Vorrichtung nach den Ansprüchen 1 bis 3, gekennzeichnet dadurch, daß in der Beschichtungskammer mehrere Anordnungen, bestehend jeweils aus Zerstäubungstargetsystem oder -systemen und äußerem Magnetron, vorhanden sind.

5. Verfahren zum mehrlagigen PVD-Beschichten von Substraten, **gekennzeichnet dadurch,** daß in einem einzigen Beschichtungsprozeß durch gesteuertes Drehen der Zerstäubungstargetsysteme um ihre Vieleckssymmetrieachsen in Winkelschritten, die den Symmetriegraden der Hohlvielecke entsprechen, Mehrlagenschichten auf Substraten abgeschieden werden, vorzugsweise ohne gesteuerte Änderung der Vakuum- und Gasparameter in der Beschichtungskammer.

6. Verfahren nach Anspruch 5, gekennzeichnet dadurch, daß durch Einmischen eines oder mehrerer Reaktivgase in die Beschichtungskammer, wobei die Reaktivgase vorzugsweise Stickstoff, Sauerstoff und/oder kohlenstoffhaltiges Gas sind, die Beschichtung reaktiv durchgeführt wird.

7. Verfahren nach den Ansprhchen 5 oder 6, gekennzeichnet dadurch, daß an Stelle der durch Gasentladungsprozesse ausgelösten Targetzerstäubung andere plasma-physikalische Verfahren zur Zerstäubung und/oder Verdampfung des Targetmaterials eingesetzt werden, vorzugsweise das Lichtbogenverdampfen und/oder das laserinduzierte Verdampfen oder daraus kombinierte Verfahren.
